(19) Europäisches Patentamt
European Patent Office
Office européen des brevets

(11) **EP 3 968 038 B1**

(12) **EUROPÄISCHE PATENTSCHRIFT**

(45) Veröffentlichungstag und Bekanntmachung des Hinweises auf die Patenterteilung:
**03.07.2024 Patentblatt 2024/27**

(21) Anmeldenummer: **20195670.3**

(22) Anmeldetag: **11.09.2020**

(51) Internationale Patentklassifikation (IPC):
**G01R 31/08** (2020.01)

(52) Gemeinsame Patentklassifikation (CPC):
**G01R 31/086;** Y04S 10/52

(54) **VERFAHREN UND EINRICHTUNG ZUM ERMITTELN EINES FEHLERORTES IN EINEM ELEKTRISCHEN ENERGIEVERSORGUNGSNETZ**

METHOD AND DEVICE FOR DETECTING A FAULT LOCATION IN AN ELECTRICAL ENERGY SUPPLY NETWORK

PROCÉDÉ ET DISPOSITIF DE DÉTERMINATION D'UN EMPLACEMENT DÉFECTUEUX DANS UN RÉSEAU D'ALIMENTATION EN ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.03.2022 Patentblatt 2022/11**

(73) Patentinhaber: **Siemens Aktiengesellschaft 80333 München (DE)**

(72) Erfinder:
• **Dzienis, Cezary 14624 Dallgow-Döberitz (DE)**
• **Jurisch, Andreas 16727 Schwante (DE)**

(74) Vertreter: **Siemens Patent Attorneys Postfach 22 16 34 80506 München (DE)**

(56) Entgegenhaltungen:
DE-A1- 2 523 006 US-A1- 2020 110 124

• GUZMAN ARMANDO ET AL: "Accurate and economical traveling-wave fault locating without communications", 2018 71ST ANNUAL CONFERENCE FOR PROTECTIVE RELAY ENGINEERS (CPRE), IEEE, 26. März 2018 (2018-03-26), Seiten 1-18, XP033335997, DOI: 10.1109/CPRE.2018.8349768 [gefunden am 2018-04-25]
• ZHENG YANGHAO ET AL: "A traveling wave fault location system based on wavelet transformation", 2019 IEEE GREEN ENERGY AND SMART SYSTEMS CONFERENCE (IGESSC), IEEE, 4. November 2019 (2019-11-04), Seiten 1-6, XP033796769, DOI: 10.1109/IGESSC47875.2019.9042397 [gefunden am 2020-03-18]
• FLUTY WESLEY ET AL: "Electric Transmission Fault Location Techniques Using Traveling Wave Method and Discrete Wavelet Transform", 2020 CLEMSON UNIVERSITY POWER SYSTEMS CONFERENCE (PSC), IEEE, 10. März 2020 (2020-03-10), Seiten 1-8, XP033787605, DOI: 10.1109/PSC50246.2020.9131271 [gefunden am 2020-07-01]

**Beschreibung**

Die Erfindung betrifft ein Verfahren zum Ermitteln eines Fehlerortes in einem elektrischen Energieversorgungsnetz, bei dem an einer Messstelle in dem Energieversorgungsnetz ein hochfrequentes Messsignal einer elektrischen Messgröße erfasst wird, das Messsignal auf das Vorhandensein einer Wanderwelle untersucht wird, ein jeweiliger Zeitpunkt erfasst wird, der das Eintreffen einer Wanderwelle an der Messstelle angibt, und die jeweiligen Zeitpunkte zum Ermitteln des Fehlerortes herangezogen werden. Die Erfindung betrifft auch eine Einrichtung zur Durchführung eines solchen Verfahrens.

Der sichere Betrieb elektrischer Energieversorgungsnetze erfordert die schnelle und zuverlässige Erkennung und Abschaltung etwaiger Fehler, wie z.B. Kurzschlüsse oder Erdschlüsse. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten, Fall findet eine Fehlerortung durch manuelle Inaugenscheinnahme statt. Dabei fährt ein Wartungsteam die fehlerhafte Leitung ab und untersucht sie auf sichtbare Fehlerstellen. Diese Vorgehensweise ist langsam und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert daraufgelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Ein grobes Ergebnis des Fehlerortes lässt sich beispielsweise durch die Feststellung der Fehlerrichtung erreichen. Diese Methode wird überwiegend in gelöschten, isolierten sowie hochohmig geerdeten Energieversorgungsnetzen mit einer radialen Struktur bzw. einem geringen Vermaschungsgrad eingesetzt. Dabei kann beispielsweise eine wattmetrische Methode verwendet werden, wie sie aus dem Europäischen Patent EP 2476002 B1 bekannt ist. Eine andere Methode zur Erkennung der Fehlerrichtung ist das sogenannte "Wischerrelais-Prinzip", das in einer möglichen ausführ-rungsform beispielsweise aus der internationalen Patentanmeldung WO 2012126526 A1 hervorgeht. Zur genaueren Fehlerortung ist bei diesen Methoden allerdings eine zusätzliche Auswertung nötig.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Die Genauigkeit dieser Methode hängt unter anderem stark von der Messgenauigkeit der verwendeten Strom- und Spannungswandler, der Genauigkeit der zur Fehlerortung verwendeten Leitungsparameter (z.B. Impedanzbelag) sowie von den gegebenen Fehlerbedingungen (z.B. Fehlerwiderstand, Last) und der Netzbeschaffenheit ab. Störungen und die Einschwingvorgänge in den Strom- und Spannungssignalen können sich negativ auf die Genauigkeit dieser Methode auswirken. Die dadurch entstehenden Messfehler können mehrere Prozent betragen. Beispielsweise ergeben sich in gelöschten oder isolierten Netzen im Erdschlussfall aufgrund der großen Nullsystemimpedanzen sehr kleine Fehlerströme in Verbindung mit einem fast vollständigen Zusammenbruch der Spannung in der fehlerbehafteten Schleife. In diesem Fall führt eine Impedanzberechnung zu einer Division (Spannung geteilt durch Strom) von annähernd Null geteilt durch Null. Damit ergeben sich sehr hohe Messfehler in der Impedanzbestimmung, die eine sinnvolle Anwendbarkeit dieser Impedanzmessverfahren verhindern.

Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht.

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- bzw. Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden.

Für die Wanderwellen-Fehlerortung wird bisher vorrangig das Prinzip der zweiseitigen Fehlerortung benutzt. Die dafür erforderliche Infrastruktur benötigt einerseits eine Kommunikationsverbindung zwischen den Messgeräten an den unterschiedlichen Messstellen und andererseits eine genaue Zeitsynchronisation der beiden Messgeräte. Alternativ kann zusätzlich zu den beiden Messgeräten im Feld eine zentrale Auswerteeinheit eingesetzt werden, die über Kommunikationsverbindungen zu beiden Messgeräten verfügt. Der damit verbundene gerätetechnische Aufwand schränkt aktuell die Attraktivität der Wanderwellen-Fehlerortung aus wirtschaftlichen Gründen auf vergleichsweise teure Hoch- und Höchstspannungsanwendungen ein. Somit werden derartige Fehlerortungssysteme bevorzugt dort eingesetzt, wo die schnellere Wiederverfügbarkeit der fehlerbehafteten Leitung eine aufwändige Infrastruktur rechtfertigt.

Durch den Einsatz einer einseitigen Wanderwellen-Fehlerortung kann die beschriebene Hürde gesenkt werden, da in diesem Fall nur noch ein Messgerät an einer Messstelle der Leitung benötigt wird und die vorhandene Automatisierungslösung der Stationsleittechnik zur Weiterleitung der Fehlerortungsergebnisse genutzt werden kann. Aus der WO 2016/118584 A1 ist ein Verfahren zur einseitigen Wanderwellen-Fehlerortung bekannt, das auf dem Vergleich von während eines geplant herbeigeführten Fehlerereignisses erzeugten Wanderwellen mit den während eines Fehlers erzeugten Wanderwellen basiert. Hierzu werden jedoch aufwendige Vergleichsmessungen für die messtechnische Aufzeichnung der Wanderwellen bei einem geplanten Fehlerereignis erforderlich.

Ferner ist aus der Veröffentlichung "Accurate and economical traveling-wave fault locating without communications" von GUZMAN ARMANDO ET AL, 2018 71ST ANNUAL CONFERENCE FOR PROTECTIVE RELAY ENGINEERS (CPRE), IEEE, 26. März 2018, Seiten 1-18, ein Verfahren zur Wanderwellen-Fehlerortung bekannt.

Der im beigefügten Anspruchssatz beschriebenen Erfindung liegt die Aufgabe zugrunde, eine möglichst einfache Fehlerortung nach dem Wanderwellenprinzip zu ermöglichen.

Zur Lösung dieser Aufgabe wird ein Verfahren der eingangs genannten Art angegeben, bei dem der Fehlerort anhand eines charakteristischen Musters einer zeitlichen Abfolge der ersten Wanderwelle und folgender Wanderwellen ermittelt wird.

Der erfindungsgemäßen Lösung liegt zunächst die Erkenntnis zugrunde, dass die durch den Fehler hervorgerufenen hochfrequenten Phänomene aufgrund ihres Wellencharakters an den Stoßstellen des Netzes, wie z.B. den Sammelschienen oder der Fehlerstelle selbst, teilweise reflektiert werden. Nach der ersten Wanderwelle, die durch den Fehler hervorgerufen wird, lassen sich an einer Messstelle somit eine Vielzahl folgender Wanderwelle registrieren, die Reflektionen von Stoßstellen oder der Fehlerstelle darstellen. Somit entsteht ein für jeden Fehlerort charakteristisches Muster, das messtechnisch erfasst und hinsichtlich des Fehlerortes ausgewertet werden kann. Da bei der erfindungsgemäßen Lösung lediglich auf aus der aktuellen Messung ermittelbare Größen zurückgegriffen wird, kann auf aufwendige Vergleichsmessungen in vorteilhafter Weise verzichtet werden. Als Messgröße kann beispielsweise der an der Messstelle fließende Strom verwendet werden.

Es wird nach dem Eintreffen der ersten Wanderwelle der Energiegehalt zumindest einer folgenden Wanderwelle bestimmt und es wird der Energiegehalt zum Ermitteln des Fehlerortes herangezogen.

Auf diese Weise kann die Fehlerortung durch Betrachtung des Energiegehalts durchgeführt werden, der an einer einzigen Messstelle aus dem Verlauf der Messgröße ermittelbar ist.

Es wird der Energiegehalt der zumindest einen folgenden Wanderwelle durch zeitliche Integration des Verlaufs des Messsignals während der Dauer eines Messfensters bestimmt.

So kann durch vergleichsweise einfache Rechenoperationen auf Basis des gemessenen Verlaufs der Messgröße der Energiegehalt bestimmt werden.

In diesem Zusammenhang kann gemäß zudem vorgesehen sein, dass die Dauer des Messfensters in Abhängigkeit von der ersten Wanderwelle festgelegt wird.

Da die Genauigkeit der Fehlerortung steigt, je kürzer das zur Bestimmung des Energiegehalts verwendete Messfenster ist, jedoch gleichzeitig eine Mindestlänge benötigt wird, um den Energiegehalt der folgenden Wanderwelle(n) feststellen zu können, ist die Wahl der Länge des Messfensters relevant für die Güte des Fehlerortungsergebnisses. Ist die erste Wanderwelle bereits scharf abgezeichnet und fällt schnell wieder ab, kann ein kürzeres Messfenster verwendet werden, ist der Verlauf der ersten Wanderwelle hingegen flacher und länger, wird auch ein längeres Messfenster benötigt.

So kann anhand der Form der ersten Wanderwelle dynamisch und adaptiv die Länge des Messfensters festgelegt werden.

Die Anzahl der betrachteten folgenden Wanderwellen (Reflektionen) kann beliebig gewählt werden. Es hat sich als vorteilhaft erwiesen, wenn der Energiegehalt von zwei auf die erste Wanderwelle folgenden Wanderwellen bestimmt wird.

Alternativ dazu kann vorgesehen sein, dass der Energiegehalt solcher auf die erste Wanderwelle folgenden Wanderwellen bestimmt wird, deren Energiegehalt eine minimale Schwelle überschreitet.

Auf diese Weise kann eine für die praktische Umsetzung größtmögliche Anzahl von Wanderwellen in die Auswertung einbezogen werden.

Auf diese Weise kann einerseits mit recht großer Zuverlässigkeit das für den Fehlerort charakteristische Muster erkannt und gleichzeitig die Dauer des Fehlerortungsprozesses kurz gehalten werden.

Eine weitere vorteilhafte Ausführungsform des erfindungsgemäßen Verfahrens sieht vor, dass die Bestimmung des Energiegehalts für mehrere angenommene Fehlerorte durchgeführt wird, wobei die Lage der für die Bestimmung des Energiegehalts verwendeten Messfenster in Abhängigkeit des jeweiligen angenommenen Fehlerortes gewählt wird, und derjenige angenommene Fehlerort als tatsächlicher Fehlerort festgelegt wird, für den der Energiegehalt am größten ist.

Da für jeden denkbaren Fehlerort in dem Energieversorgungsnetz ein anderes charakteristisches Muster von erster Welle und folgenden Reflektionen entsteht, lässt sich der tatsächliche Fehlerort durch eine Suche ermitteln, bei der für alle denkbaren Orte Fehlerorte angenommen werden und die Messfenster an den für den jeweils angenommenen Fehlerort charakteristischen Stellen platziert werden. Wenn der angenommene Fehlerort mit dem tatsächlichen Fehlerort übereinstimmt, liegen die Messfenster an den korrekten Stellen, um die Reflektionen zu erfassen, so dass der gemessene Energiegehalt entsprechend ein globales Maximum aufweist.

Konkret kann in diesem Zusammenhang vorgesehen sein, dass die Ermittlung desjenigen angenommenen Fehlerortes, für den der Energiegehalt am größten ist, mittels eines Optimierungsverfahrens durchgeführt wird.

Hierbei wird eine Zielfunktion aufgestellt, bei der der Energiegehalt des Verlaufs der Messgröße an vom angenommenen Fehlerort abhängigen Messfenstern erfasst wird. Die Zielfunktion weist hierbei mindestens ein globales Maximum auf, an dem der tatsächliche Fehlerort liegt. Daneben kann die Zielfunktion lokale Maxima aufweisen, die auf andere Stoßstellen im Netz hinweisen und für die Fehlerortung nicht relevant sind.

Der Verlauf der Zielfunktion ist üblicherweise symmetrisch zur Mitte der betrachteten Leitung des Energieversorgungsnetzes, so dass im Normalfall zwei globale Maxima entstehen werden. Daher kann gemäß einer vorteilhaften Ausführungsform des erfindungsgemäßen Verfahrens vorgesehen sein, dass zur Festlegung des tatsächlichen Fehlerortes die Polarität der auf die erste Wanderwelle unmittelbar folgenden Wanderwelle herangezogen wird.

Zur Auswahl, welches der Maxima den tatsächlichen Fehlerort angibt, kann die Polarität der ersten Reflektion ausgewertet werden. Stimmt deren Polarität mit der Polarität der ersten Wanderwelle überein, so liegt der Fehler auf der der Messstelle zugewandten Seite der überwachten Leitung. Bei gegenphasiger Polarität liegt der Fehlerort auf der der Messstelle abgewandten Seite.

Eine weitere vorteilhafte Ausführungsform des erfindungsgemäßen Verfahrens sieht vor, dass bei Vorhandensein anderer Einrichtungen zur Ermittlung des Fehlerortes deren Ergebnis der Fehlerortermittlung zur Ermittlung des tatsächlichen Fehlerortes herangezogen wird.

Auf diese Weise kann durch Heranziehen von Ergebnissen anderer Fehlerorter das Ergebnis der Fehlerortung weiter verbessert werden.

Die oben genannte Aufgabe wird auch durch eine Einrichtung zum Ermitteln eines Fehlerortes in einem elektrischen Energieversorgungsnetz gelöst, mit einer Messeinrichtung, die dazu eingerichtet ist, an einer Messstelle in dem Energieversorgungsnetz ein hochfrequentes Messsignal einer elektrischen Messgröße zu erfassen, und einer Auswerteinrichtung, die dazu eingerichtet ist, das Messsignal auf das Vorhandensein einer Wanderwelle zu untersuchen, einen jeweiligen Zeitpunkt zu erfassen, der das Eintreffen einer Wanderwelle an der Messstelle angibt, und die jeweiligen Zeitpunkte zum Ermitteln des Fehlerortes heranzuziehen.

Erfindungsgemäß ist vorgesehen, dass die Auswerteinrichtung dazu eingerichtet ist, nach dem Eintreffen der ersten Wanderwelle den Energiegehalt zumindest einer folgenden Wanderwelle zu bestimmen und den Energiegehalt zum Ermitteln des Fehlerortes heranzuziehen.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierbei zeigen

Figur 1    eine schematische Darstellung einer Leitung eines elektrischen Energieversorgungsnetzes zur Erläuterung eines zweiseitigen Fehlerortungsverfahrens nach dem Wanderwellenprinzip gemäß dem Stand der Technik;

Figur 2    eine schematische Darstellung einer Leitung eines elektrischen Energieversorgungsnetzes zur Erläuterung eines einseitigen Fehlerortungsverfahrens nach dem Wanderwellenprinzip;

Figur 3    ein Diagramm mit Messwertverläufen einer ersten Wanderwelle und folgenden Wanderwellen (Reflektionen) an einer Messstelle;

Figur 4    eine schematische Darstellung einer Leitung mit einem ersten Fehlerort und einem sich daraus ergebenden charakteristischen Muster von Wanderwellen an einer Messstelle;

Figur 5    eine schematische Darstellung einer Leitung mit einem zweiten Fehlerort und einem sich daraus ergebenden charakteristischen Muster von Wanderwellen an einer Messstelle;

Figur 6    ein Diagramm mit festgelegten Messfenstern zur Ermittlung des Energiegehalts des Verlaufs der Messgröße;

Figur 7    den Verlauf einer Zielfunktion, bei der der Energiegehalt über dem Fehlerort aufgetragen ist;

Figuren 8a-c    mehrere Diagramme mit Messverläufen von unterschiedlichen Messstellen; und

Figur 9    ein beispielhaftes Ablaufschema eines Verfahrens zur einseitigen Fehlerortung.

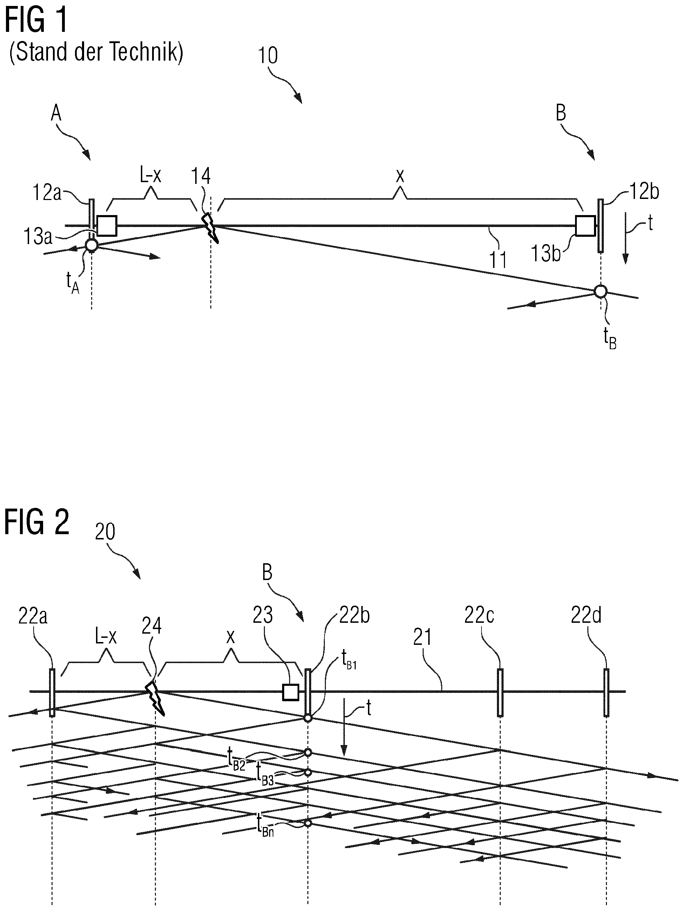

Figur 1 zeigt in schematischer Darstellung einen Teil eines elektrischen Energieversorgungsnetzes 10, in dem eine zweiseitige Fehlerortung nach dem Wanderwellenprinzip gemäß dem Stand der Technik stattfindet. Gezeigt ist eine Leitung 11. An beiden Enden der Leitung 11 sind Sammelschienen 12a, 12b angeordnet, an denen Messstellen A, B vorgesehen sind, wo mit Messeinrichtungen 13a, 13b hochfrequente Stromsignale erfasst werden, die von einem Fehler 14 an einem Fehlerort x ausgehen.

Für eine typische zweiseitige Fehlerortung nach dem Wanderwellenprinzip ist eine zeitliche Synchronisation der Messeinrichtungen 13a, 13b notwendig. Der jeweilige Zeitpunkt $t_A$, $t_B$ des Eintreffens der Wanderwelle an jeder Messstelle A, B wird erfasst und abgespeichert. Da die Ausbreitungsgeschwindigkeit der Wanderwelle meist während der Inbetriebsetzung des Systems durch entsprechende Messverfahren festgestellt wird und damit bekannt ist, kann aus den Zeitpunkten der Fehlerort x eines internen Fehlers berechnet werden. Hierzu kann folgende Gleichung verwendet werden:

$$x = \frac{L + (t_A - t_B)v}{2}$$

mit

x -    Fehlerentfernung von Messstelle B = Fehlerort,
L -    Leitungslänge, und
v -    Ausbreitungsgeschwindigkeit der Wanderwelle.

Die Genauigkeit der ermittelten Zeitpunkte beeinflusst die Genauigkeit der Fehlerortung. Wegen des einfachen Prinzips ist das zweiseitige Verfahren sehr robust. Allerdings ist durch die hochgenaue Uhrzeitführung des Abtastsystems und die Notwendigkeit einer Messung an beiden Leitungsenden die Komplexität der Hardware relativ hoch.

Figur 2 zeigt einen Teil eines Energieversorgungsnetzes 20 mit einer Leitung 21 mit mehreren Sammelschienen 22a-d. An der Sammelschiene 22b ist eine Messstelle B vorgesehen, an der mit einer Einrichtung 23 zur Fehlerortung mittels eines einseitigen Fehlerortungsverfahrens nach dem Wanderwellen-prinzip ein Fehlerort eines Fehlers 24 ermittelt wird. Zur Erläuterung der grundlegenden Vorgehensweise ist in Figur 2 die Ausbreitung der durch den Fehler 24 hervorgerufenen Wanderwelle angedeutet. Die Ausbreitung der Wanderwelle folgt den allgemeinen Reflexionsgesetzen der Wellenausbreitung und endet folglich nicht an den Terminals (z.B. Sammelschienen 22a-d) der fehlerbehafteten Leitung 21. Abhängig vom Verhältnis der Wellenimpedanzen wird ein Teil der Wanderwelle an der Stoßstelle reflektiert. Der andere Teil der Welle breitet sich in der gleichen Richtung weiter aus. Der reflektierte Teil der Welle breitet sich mit inverser Polarität aus. Der reflektierte Anteil r der Welle kann für den Strom aus dem Verhältnis der Wellenimpedanzen $Z_{L1}$ und $Z_{L2}$ an der Stoßstelle zwischen einer Leitung L1 und einer Leitung L2 berechnet werden:

$$r = \frac{Z_{L1} - Z_{L2}}{Z_{L1} + Z_{L2}}$$

Aus den Reflexionseigenschaften lässt sich für jede Fehlerstelle ein charakteristisches Muster der Wellenausbreitung erstellen. Figur 2 stellt eine mögliche Ausbreitung der Wanderwellen längst eines Stichleitungssystems mit 4 einbezogenen Sammelschienen 22a, 22b, 22c, 22d dar, deren Abgänge in Richtung niedrigerer Spannungsebenen nicht mehr gezeigt ist. Figur 2 sind hierbei die Reflektionen zu entnehmen, die sich an der Fehlerstelle sowie allen Sammelschienen 22a-d ergeben.

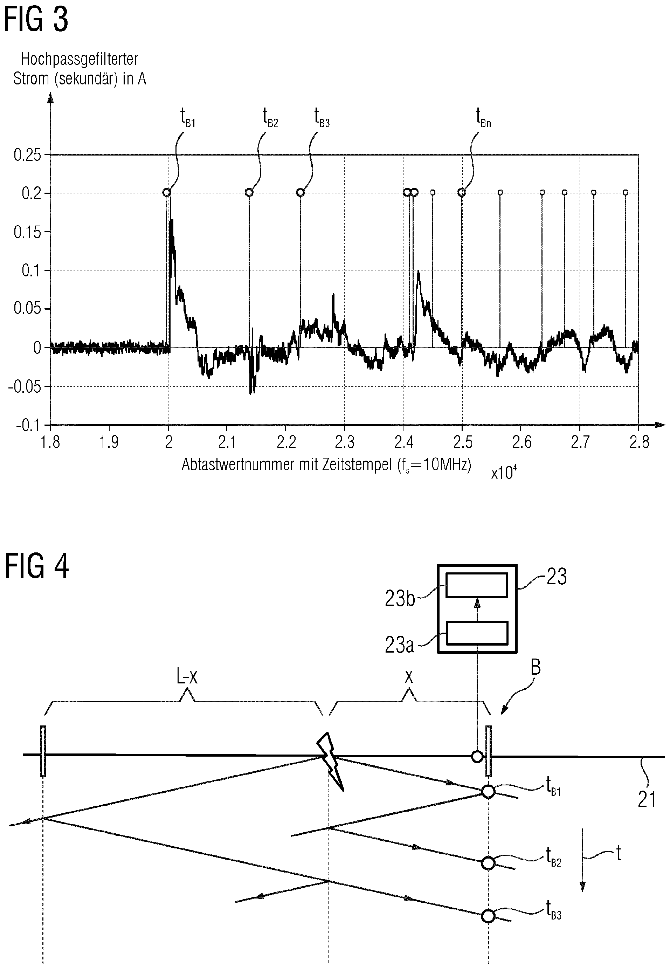

Betrachtet man den Verlauf einer Messgröße, z.B. des Stromes, an der Messstelle B über eine längere Zeitperiode (max. bis zu wenigen Millisekunden nach Eintreffen der ersten Wanderwelle), kann man im Messsignal die zahlreichen charakteristischen Muster von eintreffenden Wanderwellen beobachten. Figur 2 lässt sich in diesem Zusammenhang ein zeitlicher Verlauf des Eintreffens der Wellenfronten von Wanderwellen an der Messstelle B entnehmen, der mit den Zeitpunkten $t_{B1}$, $t_{B2}$, $t_{B3}$... $t_{Bn}$ angedeutet und in dem Diagramm in Figur 3 als Verlauf des gemessenen Stroms dargestellt ist. Durch Hochpassfilterung des hochfrequenten Stromsignals sind die Wellenfronten als exponentiell abklingende Impulse im Zeitsignal sichtbar. Man kann feststellen, dass sich aus den ermittelten Zeitpunkten des Eintreffens der reflektierten (sekundären) Wanderwellen ($t_{B2}$, $t_{B3}$,... $t_{Bn}$) in Bezug auf den Zeitpunkt des Eintreffens der ersten (primären) Wanderwelle auf den Fehlerort schließen lässt.

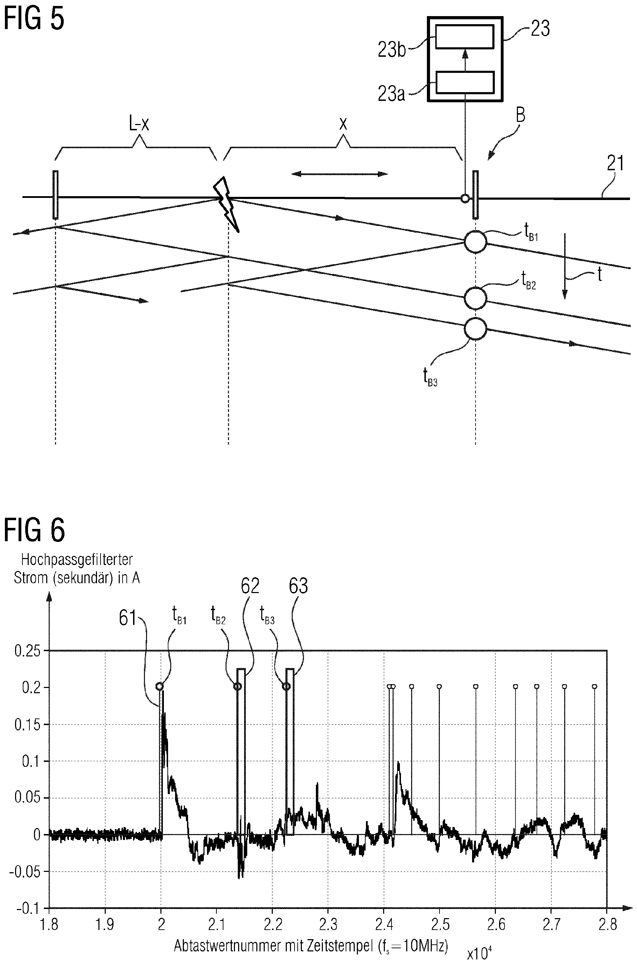

Dieses Phänomen ist in den Figuren 4 und 5 noch einmal illustriert. In Figur 4 ist für einen ersten Fehlerort x (Abstand von Messstelle B) das charakteristische Muster der Zeitpunkte $t_{B1}$, $t_{B2}$, $t_{B3}$ gezeigt. Die Messung erfolgt an der Messstelle B mit der Einrichtung 23 zur Fehlerortung. Diese weist eine Messeinrichtung 23a auf, die das hochfrequente Messsignal der Messgröße (vorliegend beispielsweise Strom) mit einer hohen Abtastrate, üblicherweise im Megahertzbereich, abtastet und die erfassten Messwerte einer Auswerteinrichtung 23b der Einrichtung 23 zur Verfügung stellt. Der Verlauf des Messsignals wird hierbei aufgenommen und über eine bestimmte Zeitdauer für die nachträgliche Auswertung abgespeichert. Diese prüft das Messsignal auf das Auftreten der ersten Wanderwelle, die quasi als Trigger für die Ermittlung des Fehlerortes anhand des charakteristischen Musters des Eintreffens von Wanderwellen dient. Auf die erste zum Zeitpunkt $t_{B1}$ eintreffende (primäre) Wanderwelle folgt zum Zeitpunkt $t_{B2}$ eine sekundäre Wanderwelle, die durch zweifache Reflektion der primären Wanderwelle entstanden ist. Zum Zeitpunkt $t_{B3}$ folgt eine weitere sekundäre Wanderwelle, die durch einfache Reflektion der sich in Richtung der Sammelschiene 22a vom Fehlerort ausbreitenden (primären) Wanderwelle entstanden ist. In entsprechender Weise könnten weitere sekundäre Wellen berücksichtigt werden. Dieses Muster aus den Zeitpunkten des Eintreffens der ersten Wanderwelle und den folgenden Wanderwellen ist charakteristisch für den in Figur 4 gezeigten ersten Fehlerort x. Entsprechendes gilt für die in Figur 5 dargestellte Situation mit einem zweiten Fehlerort x, der ebenfalls ein charakteristisches Muster von Empfangszeitpunkten erzeugt. Auf die erste zum Zeitpunkt $t_{B1}$, eintreffende (primäre) Wanderwelle folgt zum Zeitpunkt $t_{B2}$ eine sekundäre Wanderwelle, die durch einfache Reflektion der sich in Richtung der Sammelschiene 22a vom Fehlerort ausbreitenden (primären) Wanderwelle entstanden ist. Zum Zeitpunkt $t_{B3}$ folgt eine weitere sekundäre Wanderwelle, die durch zweifache Reflektion der primären Wanderwelle entstanden ist.

Ein Problem bei der Fehlerortung besteht jedoch darin, dass man Kenntnis darüber benötigt, welche Zeitpunkte der reflektierten Wanderwellen tatsächlich zur Fehlerort-Berechnung genutzt werden dürfen. Dabei gilt zunächst folgende Gleichung für die einseitige Fehlerortberechnung:

$$x = \frac{(t_{B1} - t_{B3})v}{2}$$

$$x = L - \frac{(t_{B1} - t_{B2})v}{2}$$

Abhängig von der Art der Reflektionsstelle (Fehlerort oder gegenüberliegende Sammelschiene) wendet man eine der obigen Gleichungen an. Der jeweils gewählte Bezugspunkt (im bevorzugten Fall: erste kommende Welle und ihre direkte Ableitungen) sowie die andere Abfolge der Reflektion beeinflussen die Gleichung entsprechend. Die oben angegebenen Gleichungen lassen sich dann entsprechend anpassen und weiter zur Fehlerort-berechnung nutzen.

Da mit der Zeit der Energiegehalt der Wanderwelle immer geringer wird, kann die angepasste Gleichung nur dann erfolgreich verwendet werden, wenn die mittels der Reflexionsgesetze bestimmbare Wellenamplitude noch sicher messbar ist. Das sich dann ergebende Muster der Reflektionen muss vollständig vorhanden sein. Dann können die ermittelten Zeitpunkte des Eintreffens der Wanderwellen zur Fehlerortberechnung eingesetzt werden. Durch die Reflektionen an anderen Sammelschienen und einigen topologisch-bedingten Inhomogenitäten des Netzes werden neben den nach den obigen Gleichungen erwarteten Wellenfronten jedoch auch weitere Wellenfronten eintreffen (vgl. die in Figur 2 dargestellte Situation), so dass die Auswahl der zu dem charakteristischen Muster des Fehlerorts gehörenden Wanderwellen erschwert ist.

Gemäß dem nachfolgend beschriebenen Verfahren zur Ermittlung des Fehlerortes wird eine automatisierbare einseitige Fehlerortungsmethode vorgeschlagen. Eine wesentliche Idee des Verfahrens besteht darin, das charakteristische Muster der Wanderwellen des Fehlerorts zu erkennen, indem die Signalleistung des Messsignals in solchen Messfenstern bestimmt wird, die durch die erwarteten Zeitpunkte des Eintreffens der sekundären Wanderwellen definiert sind. Die Positionen der Messfenster können für jeden angenommenen Fehlerort mittels eines Wellenausbreitungsmodells einfach bestimmt werden. Diejenige Entfernung, für die sich eine Übereinstimmung der Lage der Messfenster mit den tatsächlich erkannten Zeitpunkten der Wellenfronten ergibt, stellt die tatsächliche Fehlerentfernung dar.

Vorzugsweise werden nur die beiden ersten Reflektionen (von der Fehlerstelle und von der gegenüberliegenden Sammelschiene) zur Bildung des charakteristischen Musters in Betracht gezogen. Alternativ kann als Abbruchkriterium auch die nach Höhe der Amplitude der Reflektion genutzt werden. Hierbei werden nur solche Reflektionen berücksichtigt, deren Amplitude oberhalb eines Schwellwertes für die sichere Erkennung der Wellenfront liegt.

Wie Figuren 4 und 5 grundsätzlich zu entnehmen ist, kann für jeden angenommenen Fehlerort anhand der Modellierung der Wellenausbreitung ein Muster aus definierten Zeitpunkten des Eintreffens der Wanderwellen an der Messstelle B bestimmt werden. Diese Zeitpunkte werden bezogen auf die erste kommende Wanderwelle ermittelt. Damit lassen sich Messfenster derart platzieren, dass sie in Abhängigkeit vom angenommenen Fehlerort die das Messsignal vermessen können. Dies ist beispielhaft für die Situation in Figur 5 in dem Diagramm in Figur 6 dargestellt. Man erkennt die auf die erste detektierte Wanderwelle 61 folgend festgelegten Messfenster 62 und 63, innerhalb denen die folgenden Wanderwellen liegen müssen, wenn der angenommene Fehlerort dem tatsächlichen Fehlerort entspricht.

Basierend auf dem Zeitpunkt $t_{B1}$ der ersten Wanderwelle werden somit die Messfenster bestimmt, in denen anhand des abgespeicherten Verlaufs der Messwerte die Energie der Wanderwelle berechnet wird:

$$E = \int_{tB2}^{tB2+tw} i(t)^2 dt + \int_{tB3}^{tB3+tw} i(t)^2 dt$$

Steht die absolute Zeit nicht zur Verfügung sind die entsprechenden Zeiten $t_{B2}$ und $t_{B3}$ als Zeitdifferenzen zu $t_{B1}$ zu verstehen. Zudem ist tw die Breite des Messfensters für die Energiebestimmung.

Führt man die Berechnung des Energiegehaltes für mehrere angenommene Fehlerorte und die sich daraus ergebenden Messfenster durch, lassen sich die Ergebnisse der Energiebestimmung miteinander vergleichen. Der reale Messwertverlauf zeigt an der Stelle des tatsächlichen Fehlerortes ein Maximum des Energiegehaltes, so dass sich bei Übereinstimmung des angenommenen Fehlerortes und des tatsächlichen Fehlerortes das Maximum des Energiegehaltes feststellen lässt. In der Praxis bietet es sich an, die Bestimmung für jeden möglichen angenommenen Fehlerort durchzuführen und die Ergebnisse auf ein Maximum zu untersuchen.

Für eine effektive Bestimmung des Fehlerortes werden daher bevorzugt Optimierungsverfahren eingesetzt. Als Zielfunktion für die Optimierungsaufgabe wird die Energie des aufgezeichneten Signals innerhalb der einem angenommenen Fehlerort x entsprechenden Messfenstern bewertet:

$$E(x) = \int_{tB2(x)}^{tB2(x)+tw} i(t)^2 dt + \int_{tB3(x)}^{tB3(x)+tw} i(t)^2 dt$$

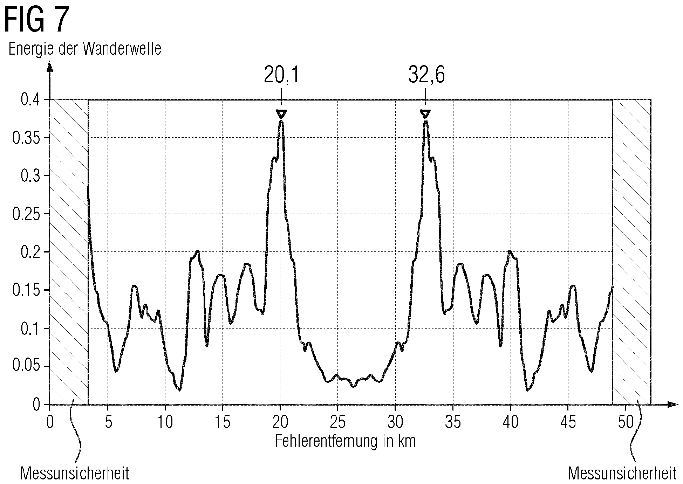

Für die Fehlerentfernung x, an der sich die Lage der Messfenster nach dem Wellenausbreitungsmodell mit dem tatsächlich aufgezeichneten Signal deckt, wird diese Zielfunktion ein Maximum aufweisen. Für das in Figur 6 dargestellte Beispiel ist diese Energiekurve in Figur 7 dargestellt. Dabei sind zwei eindeutige globale Maxima zu erkennen. Diese globalen Maxima weisen auf den Fehlerort hin. Diese Punkte sind symmetrisch gegenüber der Hälfte der Leitung.

Die Kurve zeigt, dass das Reflektionsmuster für jeden Fehlerort symmetrisch gegenüber der Leitungshälfte ist, so dass durch Analyse des Ergebnisses der Optimierung zwei mögliche Ergebnisse ermittelt werden.

Um eindeutig auf den tatsächlichen Fehlerort zu schließen, kann außerdem die Polarität der Reflektionen untersucht werden. Grundsätzlich gilt, dass Reflektion von der gegenüberliegenden Sammelschiene gegenphasig zur primären Wanderwelle verlaufen, während die Polarität der erneut vom Fehlerort reflektierten Wanderwelle identisch mit derjenigen der primären Wanderwelle ist. Bei Fehlern, die von der Messstelle aus gesehen auf der ersten Hälfte der Leitung liegen, erreicht die Reflektion von der Fehlerstelle früher als diejenige von der Sammelschiene die Messstelle (vgl. Figur 4), so dass zu erwarten ist, dass die primäre Wanderwelle und direkt folgende sekundäre Wanderwelle zum Zeitpunkt $t_{B2}$ die gleiche Polarität haben. Hingegen trifft bei einem auf der der Messstelle abgewandten Hälfte der Leitung liegenden Fehler die Wanderwelle von der gegenüberliegenden Sammelschiene zuerst ein, so dass mit einer gegenphasigen Polarität zu rechnen ist. Dem zu Figur 5 gehörenden Diagramm in Figur 6 ist zu entnehmen, dass die beiden Wanderwellen (primäre Welle und erste sekundäre Welle) gegenphasige Polaritäten aufweisen. Daher muss der Fehler auf der von der Messstelle abgewandten Hälfte der Leitung liegen. Das richtige Ergebnis ist in dem vorliegenden konkreten Beispiel somit x=32,6 km.

Im Kurvenverlauf der Figur 7 lassen sich auch andere lokale Maxima ablesen. Diese Stellen weisen auf einige Inhomogenitätspunkte auf der Leitung hin und sind für die Fehlerortung irrelevant.

In Figur 7 sind Bereiche als nicht messbar ("Messungenauigkeit") gekennzeichnet. Um im Falle von derart nah liegenden Fehlern bzw. sehr kurzer Leitungen den Fehlerort berechnen zu können, sollte die Energiefunktion zur Fehlerortbestimmung entsprechend angepasst werden und um Gewichtungsfaktoren F1 bzw. F2 erweitert werden:

$$E(x) = F1 \cdot \int_{tB2(x)}^{tB2(x)+tw} i(t)^2 dt + \int_{tB3(x)}^{tB3(x)+tw} i(t)^2 dt \quad \text{für } x < \tfrac{1}{2} L$$

$$E(x) = \int_{tB2(x)}^{tB2(x)+tw} i(t)^2 dt + F2 \cdot \int_{tB3(x)}^{tB3(x)+tw} i(t)^2 dt \quad \text{für } x \geq \tfrac{1}{2} L$$

Die Länge tw des Messfensters für die Wellenenergieberechnung beeinflusst die zu erwartende Genauigkeit der Fehlerortbestimmung. Zu lang gewählte Messfenster verbreitern das Maximum der Zielfunktion und führen somit zu einer ungenaueren Ortung. In dem dargestellten Beispiel liegt diese Limitierung bei etwa 3 km und ergibt sich aus der Länge des Messfensters von 100ns.

Um möglichst genaue Ergebnisse zu erzielen, lässt sich die Messfensterlänge von der Dynamik der ersten Wanderwelle abhängig machen. Fällt die erste Wanderwelle schnell zurück, kann die Messfensterlänge entsprechend reduziert werden. Dadurch verbessert sich die örtliche Auflösung des Fehlerortes. Für kurze Fehlerentfernungen wird eine starke Dynamik des Signals erwartet. Aus diesem Grund lässt sich die Länge des Messfensters tw reduzieren. Nahfehler werden damit genauer ortbar.

Eine weitere Verbesserung der Genauigkeit kann durch die Hinzunahme von anderen Einrichtungen zur Fehlerortung erreicht werden, die an benachbarten - nicht fehlerbetroffenen - Leitungen installiert sind. Das ermöglicht z.B. die Ortung im Falle eines Fehlers, der durch Messunsicherheit nicht ortbar ist.

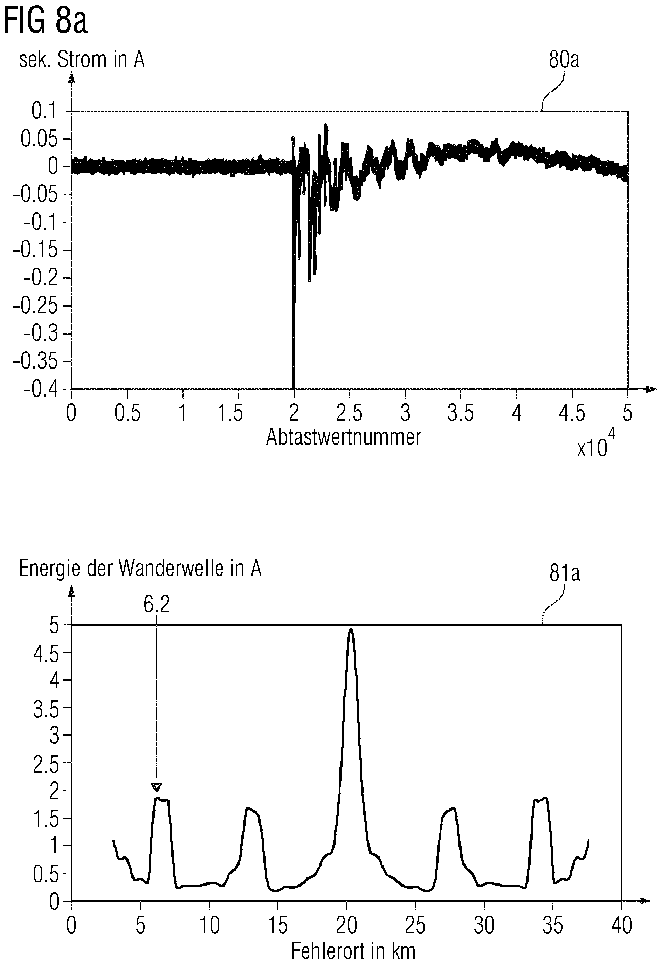

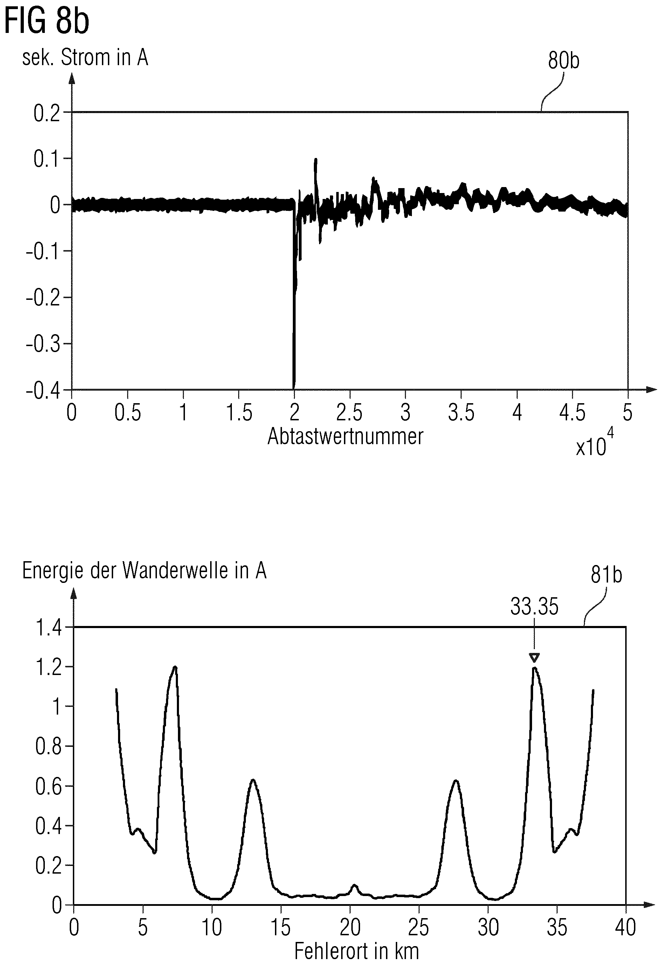

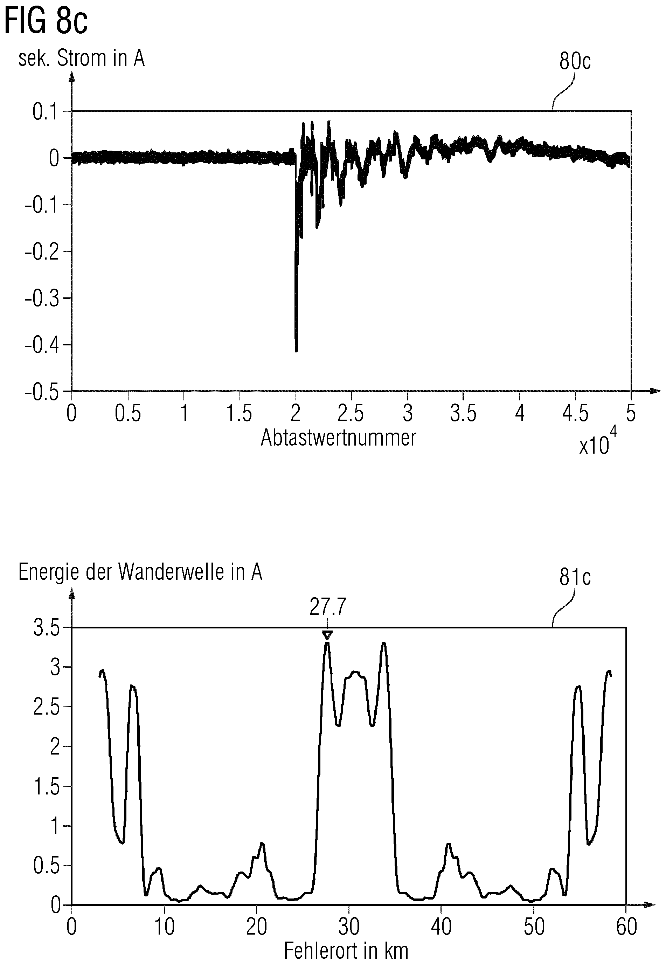

Als Beispiel dafür dient ein Fehler, der bei dem System von Figur 2 zwischen den Sammelschienen 22b und 22c liegt und eine Fehlerentfernung von x=6,87 km von der Sammelscheine 22c aufweist. Es sei angenommen, dass an jeder Sammelschiene eine Einrichtung zur einseitigen Fehlerortung vorgesehen ist. Die Einrichtungen an Sammelschienen 22c, 22b und 22d haben in dem vorliegenden Beispiel die in Figuren 8a-c dargestellten Wanderwellen aufgezeichnet. So zeigen

- Diagramm 80a den Verlauf der an Sammelschiene 22c aufgenommenen Wanderwelle;
- Diagramm 80b den Verlauf der an Sammelschiene 22b aufgenommenen Wanderwelle; und
- Diagramm 80c den Verlauf der an Sammelschiene 22d aufgenommenen Wanderwelle.

Diagramme 81a-c zeigen jeweils die Verläufe der entsprechenden Zielfunktionen. Da der Fehler zwischen den Sammelschienen 22b und 22c liegt, ist eine einseitige Fehlerortung in erster Linie durch die Einrichtungen an diesen Sammelschienen durchzuführen. Die Länge der fehlerbetroffenen Leitung beträgt im Beispiel 40,61 km. Die Einrichtung an Sammelschiene 22c erkennt den Fehler in einer Entfernung von x=6,2 km. Die benachbarte Leitung in Richtung Sammelschiene 22d ist beispielsweise 20,85 km lang, so dass es im an Sammelschiene 22c betrachteten Zeitbereich zur Reflektionen einer Wanderwelle mit der Sammelschiene 22d kommt. Diese Reflektionen beeinflusst das Ergebnis der Fehlerortung, wie in Figuren 8a-c erkennbar ist, erheblich.

Unter Berücksichtigung der Information über die direkt benachbarten Leitungen lassen sich diese Stellen aus dem Energiebild eliminieren. Andernfalls besteht die Gefahr, dass Reflektionsstellen, wie z.B. Sammelschienen, als Fehlerstelle interpretiert werden. Die Einrichtung an Sammelschiene 22b erkennt den Fehler in einer Entfernung von 33,35 km, was aus der Sicht der Einrichtung an Sammelschiene 22c einem Fehlerort von x=7,2 km entspricht. Für die Verbesserung der Fehlerortung kann auch die Einrichtung an Sammelschiene 22d eingesetzt werden. Da die Fehlerortung hier mit der Reflektion von der Gegenstelle und der Reflektion vom Fehlerort arbeitet, ist es notwendig, für die Erstellung des Reflexionsmusters die Strecke zwischen der Sammelschiene 22b und der Sammelschiene 22d zu involvieren. Aus der Berechnung ergibt sich eine Entfernung zum Fehlerort von 27,7 km was bei x=6,85 km von der Sammelschiene 22c resultiert. Somit wird durch die Ergebnisse der anderen Einrichtungen das korrekte Ortungsergebnis der Einrichtung an Sammelschiene 22c (Diagramm 81a in Figur 8a) bestätigt.

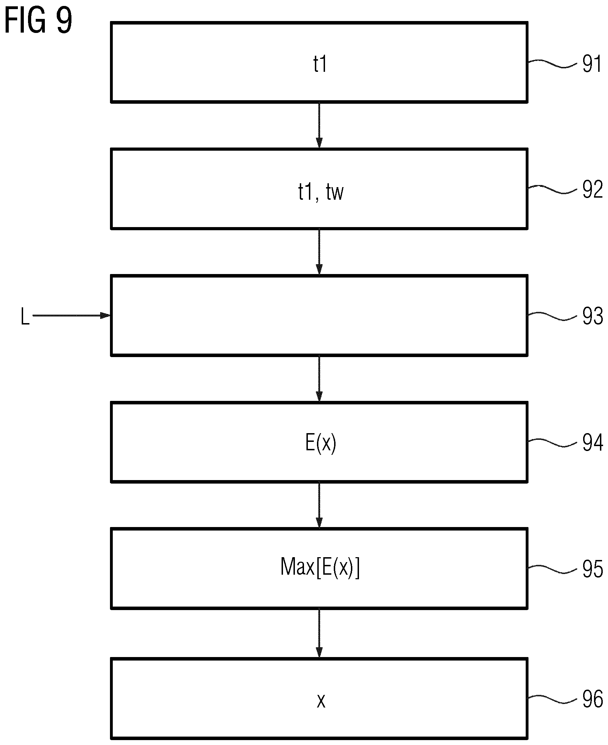

In Figur 9 ist schließlich das Verfahren zur Fehlerortung noch einmal in einem Verfahrensfließbild zusammengefasst. Gemäß einem Ausführungsbeispiel werden folgende Schritte bei der einseitigen Fehlerortbestimmung durchgeführt:

In Schritt 91 findet eine genaue Erfassung des Zeitpunkts $t_1$ des Eintreffens der ersten kommenden Welle statt. Diese erste Welle gilt als zeitliche Referenz für die weitere Fehlerortbestimmung. In Schritt 92 wird die Länge tw des Messfensters basierend auf der ersten kommenden Welle bestimmt. Von diesem Wert hängt die Messunsicherheit der Fehlerortung ab. In Schritt 93 wird bezogen auf den Zeitpunkt $t_1$ der ersten Wanderwelle und jeweils angenommene Fehlerorte die erwarteten zeitlichen Abstände der folgenden Wellen (Reflektionen) festgestellt und die Lage der entsprechenden Messfenster gesetzt. Hierfür wird die Länge L der betrachteten Leitung benötigt. In Schritt 94 wird in den festgesetzten Messfenstern der Energiegehalt des gemessenen und abgespeicherten Signals berechnet und der Verlauf der Kurve der vom Fehlerort abhängigen Zielfunktion E(x) berechnet. In Schritt 95 werden numerisch die Maxima der Kurve E(x) ermittelt. Es ergeben sich in der Regel zwei mögliche Ergebnisse für den Fehlerort. In Schritt 96 wird abschließend durch eine Analyse der Polarität der unmittelbar auf die primäre Wanderwellen folgenden ersten sekundären Wanderwelle der tatsächliche Fehlerort ermittelt und ausgegeben. Ggf. können hierbei auch die Ergebnisse anderer Einrichtungen zur Fehlerortung berücksichtigt werden.

Voranstehend wurde ein Ausführungsbeispiel eines Verfahrens zur einseitigen Fehlerortung nach dem Wanderwellenprinzip beschrieben. Während bisher eingesetzte Methoden zur Wanderwellen-Fehlerortung eine Kommunikationsverbindung und ein Gerät am anderen Ende der Leitung benötigen, kann das beschriebene Verfahren mit verhältnismäßig geringem Aufwand durchgeführt werden. Sofern mehrere Fehlerortungseinrichtungen vorhanden sind, können deren Ergebnisse über einen lokalen Stationsbus verteilt werden.

Bei dem beschriebenen Verfahren werden in vorteilhafter Weise ausgewählte Reflektionen (sekundäre Wanderwellen) genutzt, um auf den Fehlerort zu schließen. Dabei werden für eine angenommene Fehlerstelle x charakteristische Muster gebildet und entsprechende Messfenster gesetzt. Bevorzugt werden zwei relevante Reflektionen betrachtet: die erste Reflektion von der Fehlerstelle und die erste Reflektion von der gegenüberliegenden Sammelschiene. Alternativ können beliebige andere Reflektionen verwendet werden, die von der Messstelle aus gesehen hinter der Fehlerstelle liegen.

Üblicherweise werden nur die Reflektionen berücksichtigt, deren Amplitude oberhalb eines Schwellenwertes für die sichere Erkennung der Wellenfront liegt. Die Zielfunktion E(x) für den zu ermittelnden Fehlerort wird wie oben beschrieben gebildet und kann in folgenden Varianten aufgestellt werden:

- Nicht vorzeichenbehaftete Akkumulation der Energiewerte zu den Zeitpunkten des erwarteten Eintreffens einer Wellenfront für eine Fehlerentfernung x

- Vorzeichenbehaftete Akkumulation der Energiewerte zu den Zeitpunkten des erwarteten Eintreffens einer Wellenfront bewertet mit der erwarteten Amplitude der Reflektion (Kreuzkorrelation des erwarteten Reflektionsmusters für eine angenommene Fehlerentfernung x mit dem tatsächlich empfangenem Signal)

Der tatsächliche Fehlerort x wird durch Ermittlung des Maximums der Zielfunktion durch Einsatz eines Optimierungsverfahrens ermittelt. Als Optimierungsverfahren eignet sich eine Kombination aus einer linearen Suche zur groben Ermittlung des Maximums der Zielfunktion mit dem Simplex-Downhill-Algorithmus zur genauen Bestimmung des Maximums.

Weiterhin kann das Verfahren in Systemen, die zur zweiseitigen Wanderwellenfehlerortung geeignet sind, als ergänzende Funktion zur Plausibilisierung der zweiseitigen Fehlerortung bzw. zur Erhöhung der Fehlerortungs-Genauigkeit bei Fehlern in der Nähe der Leitungs-Terminals eingesetzt werden. Bei der Synchronisationsausfall kann die einseitige Methode als Backup eingesetzt werden und ist dann die einzige zuverlässige Methode zur Fehlerortung.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1.  Verfahren zum Ermitteln eines Fehlerortes in einem elektrischen Energieversorgungsnetz (20), bei dem

    - an einer Messstelle (B) in dem Energieversorgungsnetz (20) ein hochfrequentes Messsignal einer elektrischen Messgröße erfasst wird;
    - das Messsignal auf das Vorhandensein einer Wanderwelle untersucht wird;
    - ein jeweiliger Zeitpunkt erfasst wird, der das Eintreffen einer Wanderwelle an der Messstelle (B) angibt; und
    - die jeweiligen Zeitpunkte zum Ermitteln des Fehlerortes herangezogen werden;
    - der Fehlerort anhand eines charakteristischen Musters einer zeitlichen Abfolge der ersten Wanderwelle und folgender Wanderwellen ermittelt wird,

    **dadurch gekennzeichnet, dass**

    - nach dem Eintreffen der ersten Wanderwelle der Energiegehalt zumindest einer folgenden Wanderwelle bestimmt wird; und
    - der Energiegehalt zum Ermitteln des Fehlerortes herangezogen wird, und dass
    - der Energiegehalt der zumindest einen folgenden Wanderwelle durch zeitliche Integration des Verlaufs des Messsignals während der Dauer eines Messfensters bestimmt wird.

2.  Verfahren nach Anspruch 1,
    **dadurch gekennzeichnet, dass**

    - die Dauer des Messfensters in Abhängigkeit von der ersten Wanderwelle festgelegt wird.

3.  Verfahren nach einem der vorangehenden Ansprüche,
    **dadurch gekennzeichnet, dass**

    - der Energiegehalt von zwei auf die erste Wanderwelle folgenden Wanderwellen bestimmt wird.

4.  Verfahren nach einem der Ansprüche 1 bis 2,
    **dadurch gekennzeichnet, dass**

    - der Energiegehalt solcher auf die erste Wanderwelle folgenden Wanderwellen bestimmt wird, deren Energiegehalt eine minimale Schwelle überschreitet.

5.  Verfahren nach einem der vorangehenden Ansprüche 1 bis 4,
    **dadurch gekennzeichnet, dass**

    - die Bestimmung des Energiegehalts für mehrere angenommene Fehlerorte durchgeführt wird, wobei die Lage der für die Bestimmung des Energiegehalts verwendeten Messfenster in Abhängigkeit des jeweiligen angenommenen Fehlerortes gewählt wird; und
    - derjenige angenommene Fehlerort als tatsächlicher Fehlerort festgelegt wird, für den der Energiegehalt am größten ist.

6.  Verfahren nach Anspruch 4,
    **dadurch gekennichnet**, dass

    - die Ermittlung desjenigen angenommenen Fehlerortes, für den der Energiegehalt am größten ist, mittels eines Optimierungsverfahrens durchgeführt wird.

7.  Verfahren nach Anspruch 5 oder 6,
    **dadurch gekennzeichnet, dass**

    - zur Festlegung des tatsächlichen Fehlerortes die Polarität der auf die erste Wanderwelle unmittelbar folgenden Wanderwelle herangezogen wird.

8.  Verfahren nach einem der vorangehenden Ansprüche,

**dadurch gekennzeichnet, dass**

- als Messgröße der an der Messstelle (B) fließende Strom verwendet wird.

9. Verfahren nach einem der vorangehenden Ansprüche,
**dadurch gekennzeichnet, dass**

- bei Vorhandensein anderer Einrichtungen zur Ermittlung des Fehlerortes deren Ergebnis der Fehlerortermittlung zur Ermittlung des tatsächlichen Fehlerortes herangezogen wird.

10. Einrichtung (23) zum Ermitteln eines Fehlerortes in einem elektrischen Energieversorgungsnetz (20), mit

- einer Messeinrichtung (23a), die dazu eingerichtet ist, an einer Messstelle (B) in dem Energieversorgungsnetz (20) ein hochfrequentes Messsignal einer elektrischen Messgröße zu erfassen; und
- einer Auswerteinrichtung (23b), die dazu eingerichtet ist, das Messsignal auf das Vorhandensein einer Wanderwelle zu untersuchen, einen jeweiligen Zeitpunkt zu erfassen, der das Eintreffen einer Wanderwelle an der Messstelle angibt (B), und die jeweiligen Zeitpunkte zum Ermitteln des Fehlerortes heranzuziehen; wobei
- die Auswerteinrichtung (23b) dazu eingerichtet ist, den Fehlerort anhand eines charakteristischen Musters einer zeitlichen Abfolge der ersten Wanderwelle und folgender Wanderwellen zu ermitteln,

**dadurch gekennzeichnet, dass**

- die Auswerteinrichtung (23b) dazu eingerichtet ist, nach dem Eintreffen der ersten Wanderwelle den Energiegehalt zumindest einer folgenden Wanderwelle zu bestimmen, wobei der Energiegehalt zum Ermitteln des Fehlerortes herangezogen wird, und dass
- die Auswerteinrichtung (23b) dazu eingerichtet ist, den Energiegehalt der zumindest einen folgenden Wanderwelle durch zeitliche Integration des Verlaufs des Messsignals während der Dauer eines Messfensters zu bestimmen.

## Claims

1. Method for determining a fault location in an electrical energy supply network (20), in which

- a high-frequency measurement signal of an electrical measurement variable is captured at a measurement location (B) in the energy supply network (20);
- the measurement signal is examined for the presence of a travelling wave;
- a respective time that indicates the arrival of a travelling wave at the measurement location (B) is captured; and
- the respective times are used to determine the fault location;
- the fault location is determined on the basis of a characteristic pattern of a temporal sequence of the first travelling wave and subsequent travelling waves,

**characterized in that**

- after the arrival of the first travelling wave, the energy content of at least one subsequent travelling wave is determined; and
- the energy content is used to determine the fault location, and **in that**
- the energy content of the at least one subsequent travelling wave is determined by temporally integrating the profile of the measurement signal over the duration of a measurement window.

2. Method according to Claim 1,
**characterized in that**

- the duration of the measurement window is determined on the basis of the first travelling wave.

3. Method according to one of the preceding claims,
**characterized in that**

- the energy content of two travelling waves following the first travelling wave is determined.

4. Method according to one of Claims 1 to 2,
   **characterized in that**

   - the energy content of those travelling waves which follow the first travelling wave and whose energy content exceeds a minimum threshold is determined.

5. Method according to one of the preceding Claims 1 to 4,
   **characterized in that**

   - the energy content is determined for a plurality of assumed fault locations, wherein the position of the measurement windows used to determine the energy content is selected on the basis of the respective assumed fault location; and
   - that assumed fault location for which the energy content is the highest is defined as the actual fault location.

6. Method according to Claim 4,
   **characterized in that**

   - that assumed fault location for which the energy content is the highest is determined by means of an optimization method.

7. Method according to Claim 5 or 6,
   **characterized in that**

   - the polarity of the travelling wave immediately following the first travelling wave is used to define the actual fault location.

8. Method according to one of the preceding claims,
   **characterized in that**

   - the current flowing at the measurement location (B) is used as the measurement variable.

9. Method according to one of the preceding claims,
   **characterized in that**

   - if there are other devices for determining the fault location, their fault location determination result is used to determine the actual fault location.

10. Device (23) for determining a fault location in an electrical energy supply network (20), having

    - a measurement device (23a) which is configured to capture a high-frequency measurement signal of an electrical measurement variable at a measurement location (B) in the energy supply network (20); and
    - an evaluation device (23b) which is configured to examine the measurement signal for the presence of a travelling wave, to capture a respective time that indicates the arrival of a travelling wave at the measurement location (B), and to use the respective times to determine the fault location; wherein
    - the evaluation device (23b) is configured to determine the fault location on the basis of a characteristic pattern of a temporal sequence of the first travelling wave and subsequent travelling waves,

    **characterized in that**

    - the evaluation device (23b) is configured, after the arrival of the first travelling wave, to determine the energy content of at least one subsequent travelling wave, wherein

    the energy content is used to determine the fault location, and **in that**

    - the evaluation device (23b) is configured to determine the energy content of the at least one subsequent travelling wave by temporally integrating the profile of the measurement signal over the duration of a measurement window.

**Revendications**

1. Procédé de détermination d'un emplacement défectueux dans un réseau (20) d'alimentation en énergie électrique, dans lequel

   - on détecte un signal de mesure en haute fréquence d'une grandeur de mesure électrique en un point (B) de mesure du réseau (20) d'alimentation en énergie ;
   - on recherche sur le signal de mesure la présence d'une onde progressive ;
   - on détecte un instant respectif, qui indique l'arrivée d'une onde progressive au point (B) de mesure ; et
   - on tire parti des instants respectifs pour la détermination de l'emplacement défectueux ;
   - on détermine l'emplacement défectueux à l'aide d'un modèle caractéristique d'une séquence temporelle de la première onde progressive et des ondes progressives suivantes,

   **caractérisé en ce que**

   - après l'arrivée de la première onde progressive, on détermine le contenu énergétique d'au moins une onde progressive suivante ; et
   - on tire parti du contenu énergétique pour la détermination de l'emplacement défectueux, et **en ce que**
   - on détermine le contenu énergétique de la au moins une onde progressive suivante en intégrant, en fonction du temps, la courbe du signal de mesure pendant la durée d'une fenêtre de mesure.

2. Procédé suivant la revendication 1,
   **caractérisé en ce que** l'

   - on fixe la durée de la fenêtre de mesure en fonction de la première onde progressive.

3. Procédé suivant l'une des revendications précédentes,
   **caractérisé en ce que** l'

   - on détermine le contenu énergétique de deux ondes progressives suivant la première onde progressive.

4. Procédé suivant l'une des revendications 1 à 2,
   **caractérisé en ce que** l'

   - on détermine le contenu énergétique des ondes progressives suivant la première onde progressive, dont le contenu énergétique dépasse un seuil minimum.

5. Procédé suivant l'une des revendications 1 à 4 précédentes,
   **caractérisé en ce que** l'

   - on effectue la détermination du contenu énergétique pour plusieurs emplacements défectueux supposés, dans lequel on choisit la position de la fenêtre de mesure, utilisée pour la détermination du contenu énergétique, en fonction de l'emplacement défectueux supposé respectif ; et
   - on prend comme emplacement défectueux réel l'emplacement défectueux supposé, pour lequel le contenu énergétique est le plus grand.

6. Procédé suivant la revendication 4,
   dans lequel

   - on effectue au moyen d'un procédé d'optimisation, la détermination de l'emplacement défectueux supposé respectif, pour lequel le contenu énergétique est le plus grand.

7. Procédé suivant la revendication 5 ou 6,
   **caractérisé en ce que**

- pour la fixation de l'emplacement défectueux réel, on tire parti de la polarité de l'onde progressive suivant directement la première onde progressive.

8. Procédé suivant l'une des revendications précédentes,
   **caractérisé en ce que** l'

   - on utilise comme grandeur de mesure le courant passant au point (B) de mesure.

9. Procédé suivant l'une des revendications précédentes,
   **caractérisé en ce que**

   - en présence d'autres dispositifs de détermination de l'emplacement défectueux, la détermination de l'emplacement défectueux réel tire parti de leur résultat de détermination de l'emplacement défectueux.

10. Dispositif (23) de détermination d'un emplacement défectueux dans un réseau (20) d'alimentation en énergie électrique, comprenant

    - un dispositif (23a) de mesure, qui est agencé pour détecter, en un point (B) de mesure dans le réseau (20) d'alimentation en énergie, un signal de mesure en haute fréquence d'une grandeur de mesure électrique ; et
    - un dispositif (23b) d'analyse, qui est agencé pour rechercher, sur le signal de mesure, la présence d'une onde progressive, détecter un instant respectif, qui indique (B), l'arrivée d'une onde progressive au point de mesure, et tirer parti des instants respectifs pour la détermination de l'emplacement défectueux ; dans lequel
    - le dispositif (23b) d'analyse est agencé pour déterminer l'emplacement défectueux à l'aide d'un modèle caractéristique d'une séquence temporelle de la première onde progressive et des ondes progressives suivantes,

    **caractérisé en ce que**

    - le dispositif (23b) d'analyse est agencé pour déterminer, après l'arrivée de la première onde progressive, le contenu énergétique d'au moins une onde progressive suivante, dans lequel
    - on tire parti du contenu énergétique pour la détermination de l'emplacement défectueux, et **en ce que**
    - le dispositif (23b) d'analyse est agencé pour déterminer le contenu énergétique de la au moins une onde progressive suivante, en intégrant, en fonction du temps, la courbe du signal de mesure pendant la durée d'une fenêtre de mesure.

# FIG 1
(Stand der Technik)

# FIG 2

# FIG 3

Hochpassgefilterter
Strom (sekundär) in A

Abtastwertnummer mit Zeitstempel ($f_s$=10MHz)    x10⁴

# FIG 4

## FIG 5

## FIG 6

Hochpassgefilterter Strom (sekundär) in A

Abtastwertnummer mit Zeitstempel ($f_s$=10MHz) x10⁴

# FIG 7

Energie der Wanderwelle

20,1    32,6

0.4
0.35
0.3
0.25
0.2
0.15
0.1
0.05
0

0    5    10    15    20    25    30    35    40    45    50

Fehlerentfernung in km

Messunsicherheit    Messunsicherheit

# FIG 8a

sek. Strom in A ··· 80a

Abtastwertnummer
x10⁴

Energie der Wanderwelle in A ··· 81a

6.2

Fehlerort in km

# FIG 8b

sek. Strom in A

80b

Abtastwertnummer

x10⁴

Energie der Wanderwelle in A

81b

33.35

Fehlerort in km

# FIG 8c

sek. Strom in A

Abtastwertnummer

Energie der Wanderwelle in A

Fehlerort in km

FIG 9

| | |
|---|---|
| t1 | 91 |
| t1, tw | 92 |
| | 93 |
| E(x) | 94 |
| Max[E(x)] | 95 |
| x | 96 |

L →

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2476002 B1
- WO 2012126526 A1
- US 4996624 A
- US 5929642 A
- US 8655609 B2
- WO 2016118584 A1

**In der Beschreibung aufgeführte Nicht-Patentliteratur**

- Accurate and economical traveling-wave fault locating without communications. **GUZMAN ARMANDO et al.** 2018 71ST ANNUAL CONFERENCE FOR PROTECTIVE RELAY ENGINEERS (CPRE). IEEE, 26. Marz 2018, 1-18